# EUROPEAN PATENT SPECIFICATION

(11) **EP 0 822 595 B1**
(45) Date of publication and mention of the grant of the patent: **03.12.2008**
(21) Application number: 97112139.7
(22) Date of filing: 16.07.1997
(51) Int. Cl.: H01L 25/16

(54) **Hybrid module**
Hybrid-Modul
Module de type hybride

(30) Priority: 31.07.1996 JP 21927296
(43) Date of publication of application: 04.02.1998
(73) Proprietor: TAIYO YUDEN CO., LTD., Taito-ku Tokyo 110 (JP)
(72) Inventor: Suzuki, Kazutaka, Taito-ku, Tokyo 110 (JP)
(74) Representative: Goddar, Heinz J.

(56) References cited:
- DE-A- 4 031 733
- DE-A- 4 222 474
- JP-A- 4 359 587
- US-A- 5 307 240

## Description

The present invention relates to a hybrid module comprising a circuit board having a circuit pattern thereon and chip components such as a multilayer capacitor and a multilayer inductor, and semiconductor components respectively mounted on the circuit board, thereby constituting a circuit, more particularly to a hybrid module having a circuit board on which heat generate circuit components such as a field effect transistor and a power semiconductor device are mounted.

In a conventional hybrid module having a circuit board on which heat generate circuit components such as a field effect transistor and a power semiconductor are mounted, a special dissipating mans is provided for dissipating heat from the circuit components. For example, in the hybrid module disclosed in JP-A 5-13627, a dissipating fin is provided on a circuit board, and heat generate circuit components mounted on the circuit board are connected with the dissipating fin via a thermal conductive member having a shape like a leaf spring. In this hybrid module, heat generated in the circuit components is discharged to the atmosphere via the dissipating fin.

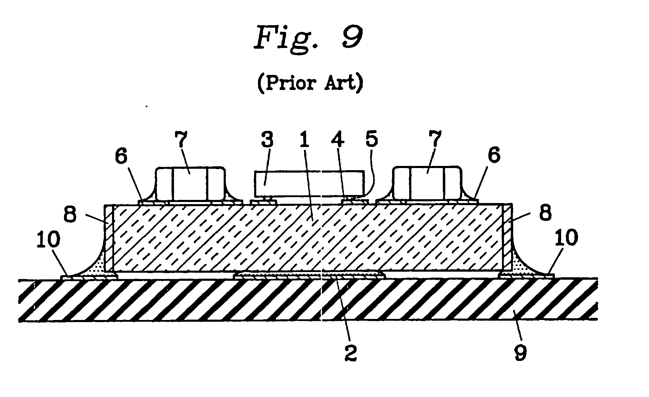

There is another conventional hybrid module having a circuit board on which heat generate components are mounted as illustrated in Fig. 9. In this hybrid module, alumina nitride ceramics are employed as a circuit board 1, and circuit components 7 and 7 each having a shape like a chip are mounted on land electrodes 6 and 6 formed on the circuit board 1, and further a circuit component 3 such as heat generate semiconductor device is mounted on the land electrodes 4 and 4 via a soldering bump 5. The circuit board 1 is mounted on a mother board (board 9) and terminal electrodes 8 and 8 of the circuit board 1 are connected with land electrodes 10 and 10 formed on the mother board (board 9). Further, the circuit board 1 and mother board (board 9) are connected with each other at the opposing surfaces thereof via a conductive film 2 which has good thermal conductivity and formed on the mother board (board 9).

The alumina nitride ceramics are noted as an insulating material having good thermal conductivity. In the aforementioned hybrid module, heat generated in the circuit component 3 mounted on the circuit board 1 is transmitted to the mother board board 9 via the circuit board 1 respectively made of alumina nitride ceramics and conductive film 2 and it is dissipated.

In the abovementioned hybrid module disclosed in JP-A 5-13627, heat which is generated at the circuit component 3 via the dissipating fin is dissipated to the atmosphere, and hence the surface area of the dissipating fin is inevitably required to be as large as possible to enhance the heat dissipating efficiency. Accordingly, a space occupied by the dissipating fin is made large in the hybrid module, which causes a problem that the hybrid module is difficult to be small sized.

On the other hand, the aforementioned another hybrid module as illustrated in Fig. 9 dispenses with a dissipating fin because heat generated in electronic devices 4 is dissipated to the mother board board 9 via the circuit board 1, and also the space occupied by the dissipating fin is omitted, namely, the hybrid module is not enlarged in its capacity because the circuit board 1 serves also as a heat dissipating or dissipating means. However, alumina nitride ceramics have good thermal conductivity but it is very expensive compared with a general substrate material made of, for example, alumina, which causes a problem to incur high cost.

DE 42 22 474 A1 discloses a circuit board, a mother board with a recess and heat generating component mounted on the circuit board opposing the mother board, component being situated within the recess of the mother board. The mother board itself has heat dissipating properties.

A hybrid module for dissipating heat generated in a circuit component 14 is provided, after it is transmitted to a mother board 19 not for dissipating the heat to the atmosphere via a dissipating fin, wherein the heat can be dissipated from the circuit component 14 to the mother board 19 without using expensive alumina nitride ceramics.

To achieve the above object, the apparatus comprises a circuit board 11, a mother board board 19, a circuit component 14 mounted on the surface of the circuit board 11 opposing the mother board 19 so that heat generated in the circuit component 14 is transmitted from the circuit component 14 to the mother board 19 directly or via a thermal conductive member 21. As a result, it is possible to obtain a hybrid module having a small capacity and also can use a circuit board made of general alumina ceramics without using alumina nitride ceramics having good thermal conductivity.

That is, the hybrid module comprises a circuit board 11, a heat generate circuit component 14 mounted on the circuit board 11, and a mother board 19 on which the circuit board 11 is mounted wherein the circuit component 14 is mounted on the surface of the circuit board 11 opposing the mother board 19 so as to transmit heat from the circuit component 14 to the mother board 19.

For example, the circuit component 14 is mounted in a recessed part 12 defined in the main surface of the circuit board 11 opposing the mother board 19. A thermal conductive member 21 having a shape like a film is formed on the mother board 19, and a package of the circuit component 14 is fixed to the thermal conductive member 21 at the surface thereof. In such a structure, heat generated in the circuit component 14 is transmitted to the mother board 19 via the thermal conductive member 21.

With such an arrangement of the hybrid module, since heat generated in the circuit component 14 is transmitted to the mother board 19 directly or via the thermal conductive member 21, and it is dissipated thereafter, it is not necessary that the circuit board 11 is especially made of alumina nitride ceramics having good conductivity but it may be made of general alumina ceramics. That is, the hybrid module of this invention can use a circuit board made of less expensive alumina or glass-epoxy resin without using a circuit board made of expensive alumina nitride ceramics, thereby reducing the cost thereof. Further, since the hybrid module of the invention dissipates heat after transmitting it to the mother board 19 without dissipating heat to the atmosphere, thereby dispensing with a dissipating fin, etc. As a result, the capacity of the hybrid module can be reduced.
Fig. 1 is a vertical cross-sectional side view of a hybrid module
Fig. 2 is a vertical cross-sectional side view of a hybrid module
Fig. 3 is a vertical cross-sectional side view of a hybrid module
Fig. 4 is a vertical cross-sectional side view of a hybrid module according to a first example of the present invention;
Fig. 5 is a vertical cross-sectional side view of a hybrid module
Fig. 6 is a vertical cross-sectional side view of a hybrid module according to a second example of the present invention;
Fig. 7 is a vertical cross-sectional side view of a hybrid module
Fig. 8 is a vertical cross-sectional side view of a hybrid module according to a third example of the present invention; and
Fig. 9 is a vertical cross-sectional side view of a conventional hybrid module.

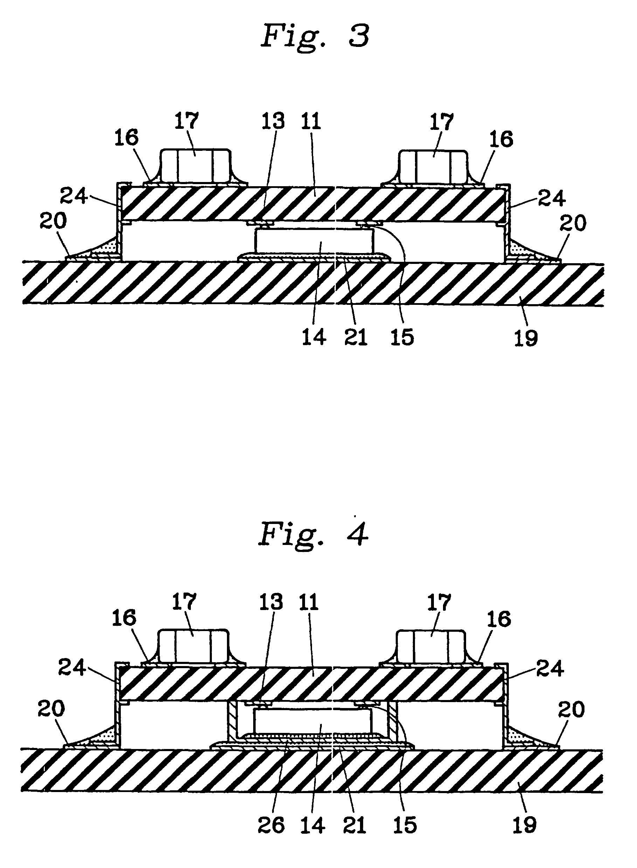

A hybrid module of the present invention will be now described in detail with reference to Figs. 4,6 and 8 showing first to third examples thereof.

A recessed part 12 is defined in a main surface of a circuit board 11, which is made of an insulating material such as glass-epoxy resin and has a circuit pattern (not shown) formed thereon. The recessed part 12 is formed, for example, by laser working to conform to the shape of a circuit component 14 which is mounted therein, and it has dimensions (length, width and depth) slightly larger than those of the circuit component 14. Land electrodes 13 and 13 are formed on a bottom surface of the recessed part 12 to be connected with terminal electrodes of the circuit component 14. The circuit board 11 has a multilayer structure, not shown, and also has a circuit pattern at the inside thereof, and the electrodes 13 and 13 are connected with this circuit pattern.

The circuit component 14 formed of a heat generate semiconductor device, etc. is accommodated in the recessed part 12 of the circuit board 11, and the terminal electrodes of the circuit component 14 are connected with the land electrodes 13 and 13. For example, heat generate semiconductor device serving as the circuit component 14 is accommodated in the recessed part 12, and soldering bumps 15 and 15 of the circuit component 14 are soldered onto the land electrodes 13 and 13. In this state, the surface of the circuit component 14 is substantially flush with the main surface of the circuit board 11. Thereafter, a filling flat 22 is filled in the recessed part 12, thereby filling the recessed part 12 except one surface of the circuit component 14 directed from the opening of the recessed part 12 to the outside.

Thereafter the circuit board is turned upside down to permit the recessed part 12 in which the circuit component 14 of the circuit board 11 is mounted to be directed downward, and circuit components 17 and 17 such as chips are mounted on the main surface of the circuit board 11, and terminal electrodes of the circuit components 17 and 17 are soldered onto land electrodes 16 and 16.

Further, the circuit board 11 is mounted on the mother board 19, and terminal electrodes 18 and 18 provided on both side surfaces of the circuit board 11 are soldered onto land electrodes 20 and 20 on the mother board 19. The terminal electrodes 18 and 18 are formed of conductive films. A conductive film as a thermal conductive member 21 is previously formed on the mother board 19 together with the land electrodes 20 and 20 at the position corresponding to the circuit component 14. At the same time when the terminal electrodes 18 and 18 of the circuit board 11 are soldered onto the land electrodes 20 and 20, the surface of the circuit component 14 is soldered onto the thermal conductive member 21.

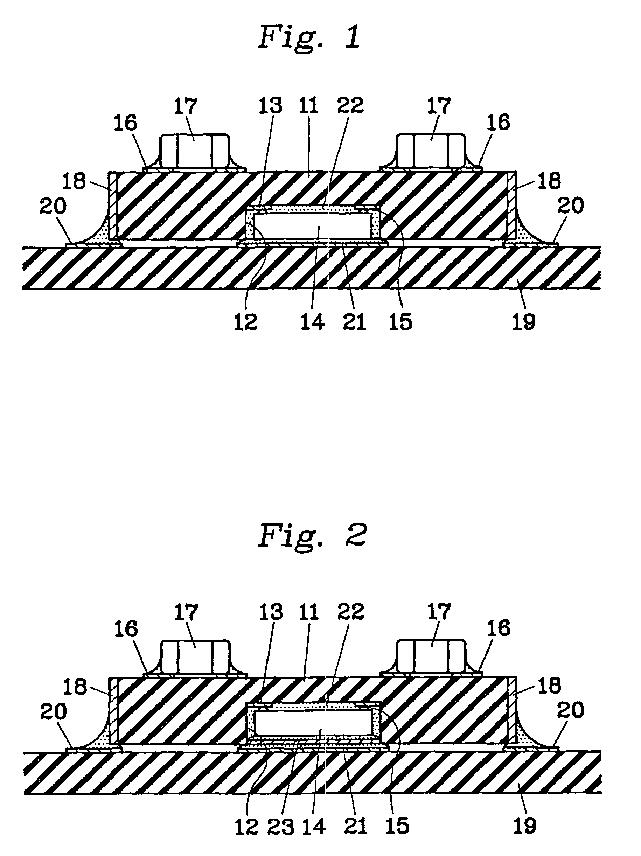

As a result, the hybrid module shown in Fig. 1 is completed. In this hybrid module, heat generated in the circuit component 14 such as heat generate semiconductor device is transmitted to the mother board 19 via the thermal conductive member 21 and then it is dissipated.

Although the surface of the circuit component 14 is directly soldered onto the thermal conductive member 21 according to the first example in Fig. 1, but a metallic plate 23 such as copper having good conductivity is previously soldered onto the surface of the circuit component 14 and the metallic plate 23 is soldered onto the thermal conductive member 21 according to the second example in Fig. 2. Accordingly the difference between the height of the circuit component 14 and the depth of the recessed part 12 is adjusted, and hence heat can be smoothly transmitted from the circuit component 14 to the mother board 19.

According to the third example in Fig. 3, the recessed part 12 is not defined in the circuit board 11 but the heat generate circuit component 14 is mounted on the lower surface of the circuit board 11. The thermal conductive member 21 formed of a conductive film is formed on the mother board 19 at the position corresponding to the circuit component 14. Lead terminals 24 and 24 are attached to both side surfaces of the circuit board 11. When the lead terminals 24 and 24 are soldered onto the land electrodes 20 and 20 of the mother board 19, the lower surface of the circuit component 14 is substantially brought into contact with the surface of the thermal conductive member 21. At the same time when the lead terminals 24 and 24 are soldered onto the land electrodes 20 and 20, the surface of the circuit component 14 is soldered onto the thermal conductive member 21. The lead terminals 24 and 24 are formed by cutting a member having a shape like a metallic plate in the shape like a belt and bending thereafter.

According to the fourth example (1st embodiment) in Fig. 4, the circuit component 14 mounted on the circuit board 11 in the third example shown in Fig. 3 is surrounded by a dissipating member 26 having high conductivity and having a shape like a metallic box, and the lower surface of the circuit component 14 is soldered onto an upper inner surface of the dissipating member 26, and further the lower surface of the dissipating member is soldered onto the thermal conductive member 21. In the fourth example, heat generated in the circuit component 14 is transmitted to the dissipating member 26, and a part of the heat is dissipated to the atmosphere from the dissipating member 26, and remaining part of the heat is transmitted to the mother board 19 via the dissipating member 26. As a result, the hybrid module can achieve more efficient heat dissipation.

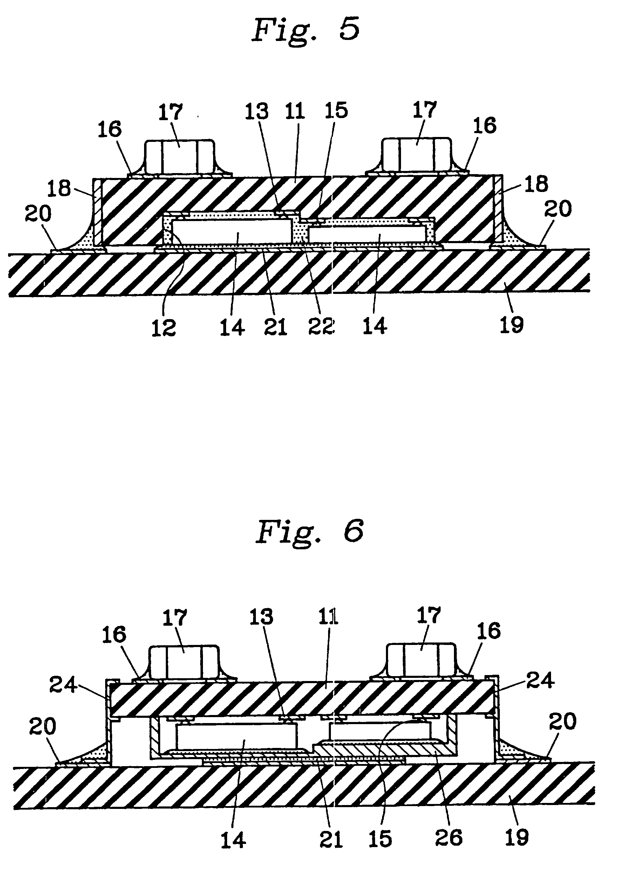

According to the fifth example in Fig. 5, the circuit component 14 in the second example in Fig. 2 is doubled, that is, two circuit components 14 and 14 having different thicknesses are mounted. In the fifth example, since the depth of the recessed part 12 is varied at the portion where the circuit components 14 and 14 are mounted, lower surfaces of the circuit components 14 and 14 are substantially flush with the lower main surface of the circuit board 11 so that the circuit components 14 and 14 are suitably mounted in the recessed part 12. The lower surfaces of the circuit components 14 and 14 are soldered onto the surface of the thermal conductive member 21 on the mother board 19 in the same manner as the second example in Fig. 2.

According to the sixth example (2nd embodiment) in Fig. 6, two circuit components 14 and 14 having different thicknesses in the fourth example in as shown in Fig. 4 are mounted on the dissipating member 26. In this example, the thickness of the dissipating member 26 on which the circuit components 14 and 14 are mounted is varied and also the height thereof at the upper inner surface thereof is also varied so that the circuit components 14 and 14 are bonded onto the dissipating member 26 while the lower surfaces of former are substantially brought into contact with the upper inner surface of the latter. The circuit components 14 and 14 and the dissipating member 26 are bonded with each other via an adhesive made of epoxy resin or silicon resin, or they may contact each other by way of a viscous material such as silicon grease. The lower surface of the dissipating member 26 is soldered onto the surface of the thermal conductive member 21 on the mother board 19 in the same manner as the fourth example (1st embodiment) in Fig. 4.

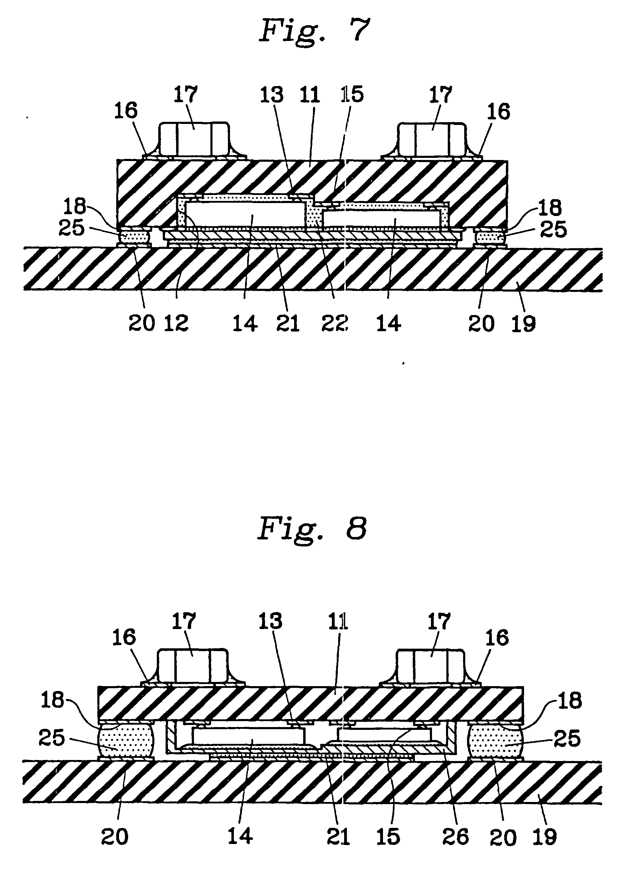

According to the seventh example in Fig. 7, the terminal electrodes 18 and 18 are provided on both sides of the bottom of the circuit board 11 in the fifth example shown in Fig. 5, and the land electrodes 20 and 20 are provided on the mother board 19 at the position corresponding to the terminal electrodes 18 and 18. The terminal electrodes 18 and 18 of the circuit board 11 and are soldered onto the land electrodes 20 and 20 on the mother board 19 while solders 25 each having a shape like a ball and interposed therebetween is subject to a reflowing and recuring treatments. In this example, since the soldering can be made between the bottom surfaces of the circuit board 11 and the mother board 19 not between the side surface of the circuit board 11 and the mother board 19, the space of the circuit board 11 to be mounted on the mother board 19 can be reduced, thereby enhancing mounting or packing density.

According to the third embodiment in (eighth example) Fig. 8, the terminal electrodes 18 and 18 are provided on both sides of the bottom of the circuit board 11 in the sixth embodiment shown in Fig. 6, and the terminal electrodes 18 and 18 are soldered onto the land electrodes 20 and 20 on the mother board 19 via the solders 25 each having a shape of a ball. Also in this example, the space of the circuit board 11 to be mounted on the mother board 19 can be reduced, thereby enhancing mounting or packing density.

The features disclosed in the foregoing description, in the claims and/or in the accompanying drawings may, both separately and in any combination thereof, be material for realising the invention in diverse forms thereof.

## Claims

1. Hybrid module comprising
- a circuit board (11),
- a mother board (19) on which the circuit board (11) is mounted, and
- heat generate circuit components (14, 14) mounted on the circuit board (11) opposing the mother board (19),
**characterized in that**
the circuit components (14, 14) are surrounded by a heat dissipating member (26), wherein the lower surface of the circuit components (14, 14) are soldered with an upper inner surface of the heat dissipating member (26) and the outer lower surface of the heat dissipating member (26) is in contact with the mother board (19).

2. Hybrid module according to one of the claims 1 and 2, **characterized in that** two circuit components (14, 14) having different thickness are mounted on the dissipating member (26), wherein the thickness and the height of the upper inner surface of the dissipating member (26) on which the circuit components (14, 14) are mounted is different.

3. Hybrid module according to one of the claims 1 to 2, **characterized in that** the circuit component (14, 14) are bonded to the dissipating member (26) via an adhesive made of epoxy resin, silicon resin or a viscous material.

4. Hybrid module according to claim 3, **characterized in that** the viscous material is silicon grease.

5. Hybrid module according to one of the preceding claims, **characterized in that** the circuit board (11) is made of alumina or glass-epoxy resin.

6. Hybrid module according to one of the preceding claims, **characterized in that** a thermal conductive member (21) is formed on the mother board (19), wherein the heat dissipating member (26) is soldered to the thermal conductive member (21) at the surface thereof.

## Patentansprüche

1. Hybridmodul mit
- einer Leiterplatte (11)
- einer Hauptplatine (19) auf der die Leiterplatte (11) befestigt ist, und
- wärmeerzeugenden Schaltungskomponenten (14, 14), die auf der Leiterplatte (11) der Hauptplatine (19) gegenüberliegend befestigt sind,
**dadurch gekennzeichnet, dass**
die Schaltungskomponenten (14, 14) von einem wärmeableitenden Element (26) umgeben sind, wobei die untere Oberfläche der Schaltungskomponenten (14, 14) mit einer oberen inneren Oberfläche des wärmeableitenden Elements (26) verlötet ist und die äußere untere Oberfläche des wärmeableitenden Elements (26) in Kontakt mit der Hauptplatine (19) ist.

2. Hybridmodul nach einem der Ansprüche 1 und 2, **dadurch gekennzeichnet, dass** zwei Schaltungskomponenten (14, 14) von verschiedener Dicke an dem wärmeableitenden Element (26) befestigt sind, wobei die Dicke und die Höhe der oberen inneren Oberfläche des wärmeableitenden Elements (26), an dem die Schaltungskomponenten (14, 14) befestigt sind, verschieden ist.

3. Hybridmodul nach einem der Ansprüche 1 bis 2, **dadurch gekennzeichnet, dass** die Schaltungskomponenten (14, 14) mit dem wärmeableitenden Element (26) mittels eines Klebers verbunden sind, der aus Epoxidharz, Silikonharz oder einem viskosen Material hergestellt ist.

4. Hybridmodul nach Anspruch 3, **dadurch gekennzeichnet, dass** das viskose Material Silikonfett ist.

5. Hybridmodul nach einem der vorhergehenden Ansprüche, **dadurch gekennzeichnet, dass** die Leiterplatte (11) aus Aluminium oder Glass-Epoxidharz hergestellt ist.

6. Hybridmodul nach einem der vorhergehenden Ansprüche, **dadurch gekennzeichnet, dass** ein wärmeleitendes Element (21) auf der Hauptplatine (19) gebildet ist, wobei das wärmeableitende Element (26) an die Oberfläche des wärmeleitenden Elements (21) gelötet ist.

## Revendications

1. Module hybride comprenant
- une carte de circuit imprimé (11);
- une carte mère (19) sur laquelle est montée la carte de circuit imprimé (11), et
- des composants de circuit générateurs de chaleur (14, 14) montés sur la carte de circuit imprimé (11) en face de la carte mère (19),
**caractérisé en ce que**
les composants de circuits (14, 14) sont entourés par un élément dissipateur de chaleur (26), dans lequel la surface inférieure des composants de circuit (14, 14) sont soudés avec une surface interne supérieure de l'élément dissipateur de chaleur (26) et la surface inférieure externe de l'élément dissipateur de chaleur (26) est en contact avec la carte mère (19).

2. Module hybride selon l'une des revendications 1 et 2, **caractérisé en ce que** deux composants de circuit (14, 14) d'une épaisseur différente sont montés sur l'élément dissipateur (26), dans lequel l'épaisseur et la hauteur de la surface interne supérieure de l'élément dissipateur (26) sur laquelle sont montés les composants de circuit (14, 14) sont différentes.

3. Module hybride selon l'une quelconque des revendications 1 à 2, **caractérisé en ce que** les composants de circuit (14, 14) sont assujettis à l'élément dissipateur (26) par l'intermédiaire d'un adhésif réalisé en résine époxy, résine de silicone, ou matière visqueuse.

4. Module hybride selon la revendication 3, **caractérisé en ce que** la matière visqueuse est de la graisse de silicone.

5. Module hybride selon l'une quelconque des revendications précédentes, **caractérisé en ce que** la carte de circuit imprimé (11) est réalisée en alumine ou verre-résine époxy.

6. Module hybride selon l'une quelconque des revendications précédentes, **caractérisé en ce qu'**un élément conducteur thermique (21) est formé sur la carte mère (19), dans lequel l'élément dissipateur de chaleur (26) est soudé sur l'élément conducteur thermique (21) au niveau de la surface de celui-ci.
